# FASCICULE DE BREVET EUROPEEN

(11) **EP 0 573 348 B1**
(45) Date de publication et mention de la délivrance du brevet: **26.03.1997**
(21) Numéro de dépôt: 93401398.8
(22) Date de dépôt: 02.06.1993
(51) Int. Cl.: C23C 16/14, C23C 16/44

(54) **Procédé de dépôt de cuivre sur un substrat et dispositif pour sa mise en oeuvre**
Verfahren zur Abscheidung von Kupfer auf ein Substrat und Vorrichtung zur Durchführung des Verfahrens
Process for deposition of copper on a substrate and device for carrying out the process

(30) Priorité: 03.06.1992 FR 9206706
(43) Date de publication de la demande: 08.12.1993
(73) Titulaire: FRANCE TELECOM, 75015 Paris (FR); CENTRE NATIONAL DE LA RECHERCHE SCIENTIFIQUE (CNRS), 75794 Paris Cédex 16 (FR)
(72) Inventeur: Torres, Joaquim, F-38950 Saint Martin le Vinoux (FR); Palleau, Jean, F-38240 Meylan (FR); Madar, Roland, F-75700 Paris (FR); Bernard, Claude, F-38320 Brie et Angonnes (FR)
(74) Mandataire: Ores, Irène

(56) Documents cités:
- EP-A- 0 482 265
- GB-A- 2 057 018
- US-A- 3 787 236
- US-A- 4 239 819
- PATENT ABSTRACTS OF JAPAN vol. 13, no. 61 (C-567)(3409) 10 Février 1989 & JP-A-63 250 463 (ULVAC CORPORATION) 18 Octobre 1988

## Description

La présente invention est relative à un procédé de dépôt en phase vapeur de cuivre sur un substrat, ainsi qu'à un dispositif pour la mise en oeuvre de ce procédé.

La méthode de dépôt chimique de métal en phase vapeur (CVD) est largement utilisée pour produire des couches minces de métal, de bonne qualité ; cette méthode a trouvé application dans de nombreuses industries et notamment dans l'industrie électronique.

Dans cette dernière industrie, des dépôts d'aluminium, de chrome, de cuivre, d'argent, d'or ou de nickel, etc.. sont, en effet, particulièrement utilisés dans la réalisation de circuits électroniques complexes ou hybrides, à partir de plusieurs "puces" assemblées sur un même substrat de silicium et/ou pour la production des lignes d'interconnexion.

De manière générale, ces couches sont habituellement réalisées sous vide, par thermo-évaporation ou bien par pulvérisation cathodique ; le dépôt peut être fait soit sur toute la surface du substrat, puis gravé, soit au travers d'un masque, de façon à obtenir directement le dessin désiré.

Dans la mesure où il est préférable, dans ce domaine, de déposer le métal à des températures qui sont suffisamment basses, notamment pour permettre de réaliser le dépôt en présence de substrats sensibles à la température, des techniques CVD adaptées à de telles situations, ont été décrites.

La Demande de Brevet européen EP 297 348, au nom de IBM, décrit une méthode de dépôt chimique de cuivre en phase vapeur (technique CVD), utilisant comme produit de départ ou précurseur, un complexe organométallique du type cyclopentadiénylmétal, sous forme gazeuse et comprenant un noyau cyclopentadiényle, un ligand donneur de deux électrons (phosphines trivalentes, amines et arsines) et un métal du groupe IB dans un état d'oxydation +1.

Le substrat sur lequel le dépôt doit être fait est chauffé, de manière à ce que la réaction de décomposition des vapeurs du complexe précurseur se fasse au niveau dudit substrat et conduit au dépôt du métal (groupe IB) au niveau dudit substrat.

Cette réaction, effectuée à basse température, l'utilisation du métal dans son état d'oxydation +1 et la dimérisation du noyau cyclopentadiényle en une molécule stable et volatile sont les caractéristiques essentielles qui conduisent au dépôt de métal sur un substrat dans les conditions décrites dans cette Demande EP 297 348.

D'autres documents décrivent l'utilisation d'autres précurseurs organométalliques, tels que des composés de type trifluoroacétylacétone ou acétylacétonate.

Le Brevet US 4 842 891, au nom de HITACHI LTD, décrit une méthode de formation d'une couche de cuivre par CVD, dans laquelle le produit de départ est du nitrate de cuivre. La vapeur de nitrate de cuivre est réduite avec un gaz réducteur à faible poids moléculaire tel que le monoxyde de carbone, l'hydrogène, le méthane, l'ammoniac, de telle sorte que le cuivre métallique soit précipité sur la surface du substrat, maintenu à une température de 200-650°C. Les conditions de la réaction sont plus particulièrement décrites : la pression dans la chambre de réaction doit être comprise entre 0,1 et 3 torrs et le rapport nitrate de cuivre/gaz réducteur est supérieur à un rapport stoechiométrique.

Toutefois, ces techniques CVD présentent un certain nombre d'inconvénients :
- le dépôt est de mauvaise qualité et comprend notamment des impuretés (carbone, oxygène...) ; ceci est notamment le cas dans les techniques CVD utilisant comme produit de départ un composé organométallique, dans lesquelles les impuretés telles que le carbone ou l'oxygène formé lors de la décomposition du composé organométallique -qui peut, en outre, se révéler instable,- subsistent en quantités importantes dans la couche de métal et notamment de cuivre obtenu ;
- et/ou les températures de réaction sont excessives ;
- et/ou la vitesse de dépôt, de l'ordre de 0,1-0,5 µm/h, est trop faible.

De telles techniques sont, en conséquence, d'application industrielle peu aisée.

Les premières techniques de CVD décrites, mettaient en oeuvre du CuCl₂ (état d'oxydation +2) à des températures comprises entre 400 et 1 200°C et présentaient l'inconvénient d'avoir des températures de réaction excessives.

L'article au nom de C. LAMPE-ÖNNERUD et al., paru dans J. Physique IV (Colloque C₂), Suppl. J. Physique II, 1991, 1, 881-888, décrit une méthode de dépôt chimique de cuivre en phase vapeur, utilisant comme précurseur du CuCl ; les Auteurs de cet article ont montré que pour l'obtention d'un dépôt de cuivre sur un substrat, l'évaporation du CuCl à partir d'un produit solide tel qu'une poudre est une étape critique du procédé.

Dans les conditions décrites dans cet article, le CuCl a été évaporé à une température comprise entre 300 et 350°C et les températures de dépôt étaient comprises entre 350 et 500°C.

Les variations dans le taux d'évaporation sont essentiellement dues à deux facteurs : déviation de l'équilibre à l'évaporation et formation d'hydroxychlorure sur la surface du produit solide ; les Auteurs de cet article ont conclu qu'un dépôt reproductible à partir de CuCl ne pourrait être obtenu que par un traitement approprié du produit solide.

Ils ont, par ailleurs, plus particulièrement étudiés deux substrats : SiO₂ et Si(III).

Des dépôts de cuivre, sur un substrat SiO₂ (température d'évaporation : 350°C ; température de dépôt : 500°C ; pression partielle de CuCl : 1,2 Pa, en présence d'hydrogène comme gaz réducteur), d'une épaisseur moyenne 1,5 µm, sont déposés en 5 h, ce qui correspond à une vitesse de dépôt d'environ 0,3 µm/h.

Dans les conditions décrites dans cet article, du chlore est détecté à la surface des particules de cuivre déposées ; de plus, dans le cas où le substrat est du Si(III), une certaine instabilité du dépôt est observée.

La méthode exposée dans cet article présente l'inconvénient d'entraîner un dépôt de mauvaise qualité (impuretés), à vitesse trop faible (0,3 µm/h) pour une application industrielle.

Il ressort également de ce document, que la principale difficulté dans la mise en oeuvre de précurseurs inorganiques tels que CuCl réside dans la faible tension de vapeur de ce dernier, à température ambiante et donc à la difficulté d'obtenir une concentration dans la phase vapeur suffisamment grande pour conduire à des vitesses de dépôt de quelques µmètres par minute.

Ceci montre que les sources d'halogénures de cuivre à sublimation, à partir de la phase solide, sont généralement peu satisfaisantes car les variations de propriétés de surface du solide, en cours de sublimation, conduisent à des variations de vitesse de sublimation importantes et donc, à une variation des débits d'halogénures gazeux.

La demande de brevet EP-A- 482 265 décrit une méthode de dépôt en phase vapeur d'une couche mince de cuivre sur un substrat par formation, à l'extérieur de la chambre de réaction, d'un flux gazeux contenant un halogénure de cuivre par passage d'HCl dans un tube de cuivre chauffé à 1000°C, introduction de ce flux dans la chambre de réaction et sa réduction par de l'hydrogène préalablement activé à l'aide d'un filament métallique catatytique porté à haute température. Cette méthode conduit à une vitesse de dépôt de 0,5 µm par heure.

La présente invention s'est en conséquence donné pour but de pourvoir à un procédé de dépôt de métal en CVD, qui répond mieux aux besoins de la pratique que les procédés actuellement utilisés, en permettant l'obtention d'une vitesse de dépôt de quelques micromètres par minute, dans des conditions de pression et de température particulièrement bien adaptées aux substrats à traiter et permettant le dépôt homogène ou sélectif d'une couche de métal de bonne qualité.

La présente invention a pour objet un procédé de dépôt de cuivre en phase vapeur, sur un substrat, par réduction d'un halogénure de cuivre à l'état gazeux, caractérisé en ce qu'il comprend :
(a) la production dudit halogénure de cuivre, sous forme CuCl, *in situ*, à partir d'un moyen de production (11) inclus dans une chambre de réaction (10) contenant le substrat, par mise en contact de chlore gazeux avec du cuivre solide porté à une température comprise entre 500°C et 700°C, et
(b) la réduction, -dans ladite chambre de réaction maintenue à une pression totale, comprise entre 13,3 et 133,3 pascals (0,1 et 1 torr)-, dudit halogénure de cuivre gazeux produit au cours de l'étape (a) et dont la pression partielle est comprise entre 1,33 et 13,3 pascals (0,01 et 0,1 torr), en présence d'au moins un gaz réducteur, lequel gaz a une pression partielle de l'ordre de celle de l'halogénure de cuivre, pour l'obtention d'un dépôt de métal pur, à une vitesse de l'ordre du µm par minute, sur ledit substrat porté à une température comprise entre 200°C et 400°C,

Selon un mode de mise en oeuvre avantageux dudit procédé, le gaz réducteur est choisi dans le groupe comprenant l'hydrogène, SiH₄, Si₂H₆, Si₃H₈, SiH₂Cl₂, SiHCl₃, SiH₃Cl.

Selon un autre mode de mise en oeuvre avantageux dudit procédé, le substrat est choisi dans le groupe qui comprend les substrats semi-conducteurs, notamment à base de silicium et les substrats en matière plastique.

Selon la structure du substrat, le dépôt peut être homogène ou sélectif.

Selon une disposition avantageuse de ce mode de mise en oeuvre, lorsque la surface du substrat est de nature homogène, silicium ou métal, on obtient un dépôt en couche homogène de l'ordre du µm/min.

Selon une autre disposition avantageuse dudit mode de mise en oeuvre, lorsque la surface du substrat présente des structures de natures différentes (i.e. zones de silicium nu et zones d'oxyde de silicium), ladite couche de métal se dépose sélectivement au niveau de certaines zones, silicium ou métal, seulement.

Par exemple, en changeant localement la nature de la surface d'un substrat en silicium oxydé par une suite d'étapes de photolithographie et de gravure formant notamment des lignes de silicium dénudé, on observe un dépôt de métal (cuivre notamment), seulement dans les zones de silicium nu alors que le métal ne se dépose pas dans les zones de silicium oxydé. Une telle sélectivité est également observée avec des substrats où une partie de la surface est oxydée, le reste de la surface étant recouvert d'un métal, cuivre ou chrome, par exemple.

Il en est de même pour des substrats présentant des zones de cuivre et des zones d'isolant organique ; dans ce cas, on obtient un dépôt de métal sans que le diélectrique ne présente de traces de dépôt métallique.

Un tel procédé est particulièrement avantageux dans la métallisation des derniers niveaux d'interconnexions des circuits intégrés, dans la réalisation de réseaux d'interconnexions pour circuits hybrides, ainsi que dans la métallisation des matières plastiques.

Selon un autre mode de mise en oeuvre avantageux dudit procédé, les gaz réactifs (halogène et/ou gaz réducteur) sont associés à un gaz porteur neutre.

La présence de ce gaz porteur, qui peut avantageusement être de l'argon, assure le transport des gaz réactifs et évite une réaction en phase homogène ; sa pression partielle représente avantageusement environ 80 % de la pression totale.

La présente invention a également pour objet un dispositif pour la mise en oeuvre du procédé conforme à l'invention, du type comprenant une chambre de réaction incluant un substrat, des moyens de chauffage dudit substrat et au moins une source de gaz réducteur, caractérisé en ce que ladite chambre de réaction inclut, en outre, un moyen de production *in situ* d'un halogénure de métal gazeux, qui comprend au moins en combinaison :
. une source d'halogène gazeux, associée à des moyens de régulation du débit d'entrée dudit halogène ;
. un support contenant un métal sous forme solide ;
. des moyens d'homogénéisation du flux de sortie de l'halogénure métallique gazeux formé, vers le substrat ; et
. des moyens de chauffage et de régulation de sa température,
lequel moyen de production d'halogénure métallique gazeux entoure ledit substrat et permet une injection radiale uniforme de l'halogénure sur le substrat.

De manière avantageuse, la régulation des débits de gaz est assurée par des débitmètres massiques.

Selon un mode de réalisation avantageux dudit dispositif, ledit moyen de production d'halogénure métallique gazeux comprend en outre une source de gaz porteur.

De manière avantageuse, un tel dispositif permet de réaliser, dans le cas du cuivre, par exemple, une source de CuCl gazeux à débit ajustable, car dans les conditions de température et de pression telles que définies dans le procédé conforme à l'invention, la cinétique de formation de CuCl, à partir de Cl₂ gazeux et de cuivre solide, est définie et contrôlable ; en effet, un tel dispositif, permettant une injection radiale, donc uniforme de l'halogénure de cuivre, conduit à l'obtention d'une concentration dans la phase vapeur suffisamment grande pour obtenir des vitesses de dépôt de métal de l'ordre du micromètre par minute.

Outre les dispositions qui précèdent, l'invention comprend encore d'autres dispositions, qui ressortiront de la description qui va suivre, qui se réfère à des exemples de mise en oeuvre du procédé conforme à l'invention et à une description détaillée du dispositif de l'invention, avec référence aux dessins annexés dans lesquels :

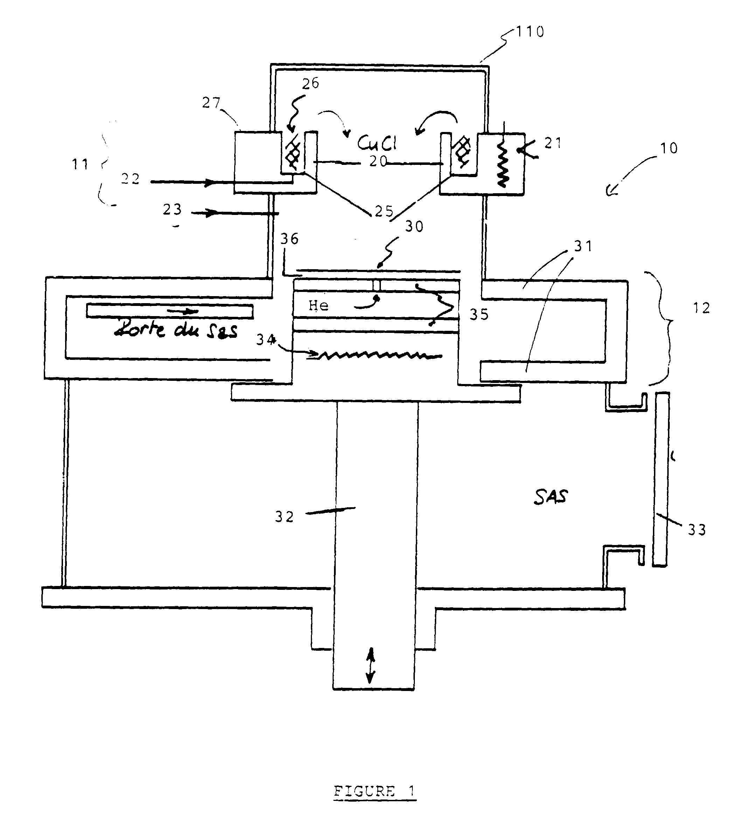

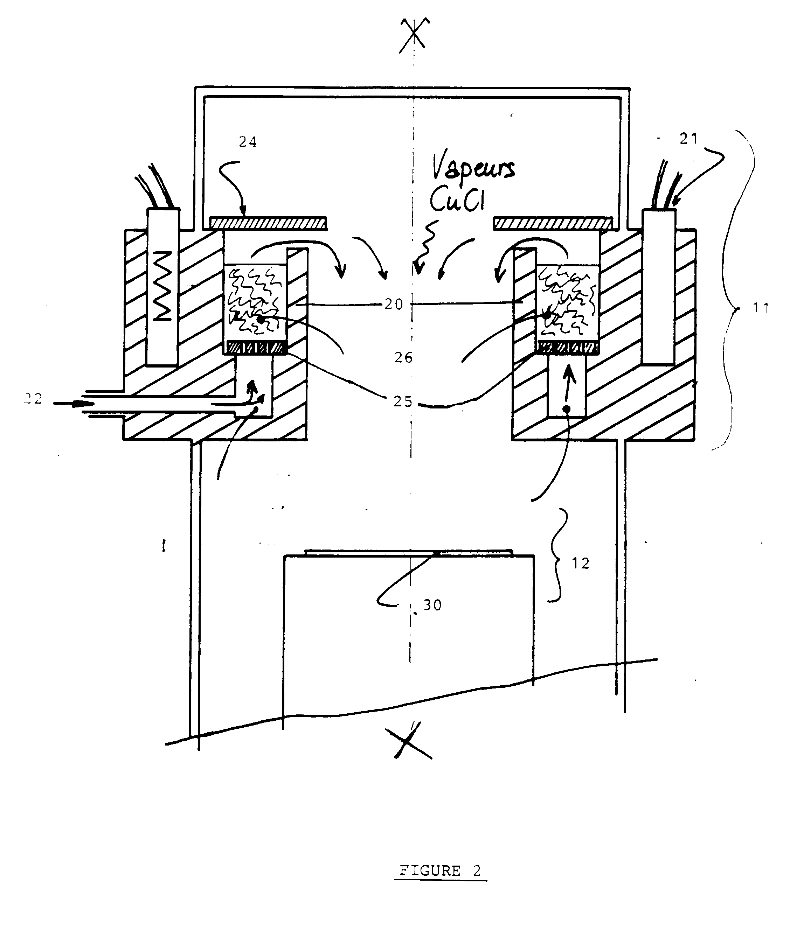

- les figures 1 et 2 représentent un mode de réalisation du dispositif conforme à l'invention, en coupe longitudinale, dans lequel le moyen de production *in situ* d'halogénure métallique (cuivre, dans la réalisation représentée) entoure le substrat (forme annulaire).

Il doit être bien entendu, toutefois, que ces dessins et les parties descriptives correspondantes, ainsi que les exemples, sont donnés uniquement à titre d'illustration de l'objet de l'invention, dont ils ne constituent en aucune manière une limitation.

La figure 1 représente un dispositif conforme à l'invention, en coupe longitudinale, qui comprend avantageusement une chambre de réaction 10, incluant à la fois un moyen de production d'halogénure de cuivre gazeux 11 et une zone de dépôt de cuivre 12 sur un substrat 30.

Le moyen de production d'halogénure de cuivre gazeux 11 comprend, dans la réalisation représentée aux figures 1 et 2 :
. une coupelle (ou support 20) annulaire fermée par un fond perforé 25, dans laquelle peut être logé un métal 26, notamment du cuivre sous forme solide. A la coupelle 20, sont associés des moyens de chauffage et de régulation de la température 21, permettant le chauffage de l'ensemble du moyen de production d'halogénure, lesquels moyens permettent la mise en température du cuivre à environ 650°C ; dans la réalisation représentée, ces moyens de chauffage et de régulation de la température 21 sont représentés par une résistance et peuvent être réalisés par une série de thermo coaxes noyés dans la paroi du moyen de production et régulés en température par un contrôle de la puissance électrique dissipée dans les résistances ;
. le chlore gazeux est envoyé par l'intermédiaire du conduit 22, qui débouche à partir de l'extérieur du moyen de production 11, au dessous du fond perforé 25 de la coupelle 20, sur le cuivre solide 26 chauffé ; le flux dudit halogène est homogénéisé par une série de chicanes, non représentées aux figures 1 et 2 ; dans la réalisation représentée auxdites figures 1 et 2, le conduit 22 véhicule également le gaz porteur, qui peut notamment être de l'argon ;
. au dessus de la coupelle 20 est déposé un déflecteur 24, représenté à la figure 2, sous forme d'une plaque annulaire, qui renvoie les vapeurs d'halogénure métallique formées vers l'axe X-X (figure 2) de la chambre de réaction et vers le substrat 30 ; et
. les parois 110 de la chambre de réaction 10 sont associées à un moyen de chauffage et de régulation de la température, qui permet de maintenir la température de ces parois à environ 250°C, pour éviter le dépôt de CuCl sur ces dernières.

Ce moyen de production d'halogénure de cuivre gazeux 11 permet l'injection dudit halogénure dans la chambre de réaction proprement dite, dans sa partie centrale X-X, également maintenue à une température d'environ 250°C.

Dans la réalisation représentée aux figures 1 et 2, le débit du CuCl gazeux est contrôlé par le débit du chlore envoyé dans le moyen 11.

Le CuCl formé se trouve au voisinage du substrat 30 et est mis en contact avec un gaz réducteur ou un mélange de gaz réducteurs, envoyé dans la chambre de réaction 10, par l'intermédiaire du conduit 23, qui débouche à partir de l'extérieur de ladite chambre de réaction 10, juste au dessus du substrat 30 ; les débits d'entrée desdits gaz réducteurs sont régulés à l'aide de débitmètres massiques.

La réduction de l'halogénure métallique gazeux en métal solide se fait alors dans la zone de dépôt de cuivre 12, qui comprend avantageusement, dans la réalisation représentée à la figure 1 :
. un substrat 30, associé à des moyens de chauffage 34, qui dans ce mode de réalisation sont représentés, de manière non limitative, par une lampe halogène située en arrière d'un hublot en quartz 35, associée à une couche d'hélium 36, située sous le substrat 30 (plaque de silicium par exemple), de manière à homogénéiser la température dudit substrat ; sur le substrat 30 va se former, dans les conditions définies dans le procédé conforme à l'invention, une couche de métal pur (cuivre dans la réalisation représentée), à une vitesse de l'ordre du µm/min. ; ledit substrat 30 est porté par un support 32, qui peut être déplacé selon un axe vertical, de manière à régler la distance entre la source de production d'halogénure métallique et le substrat, pour qu'elle soit de l'ordre du cm ;
. des moyens de pompage 31 des composés volatils formés lors de la réaction de réduction du CuCl ; et
. une paroi amovible 33, permettant le chargement de la chambre de réaction 10.

Le dispositif conforme à l'invention a l'avantage de prévoir une source d'halogénure produite *in situ*, solidaire de la chambre de réaction.

De manière avantageuse, dans le dispositif conforme à l'invention, qui inclut un moyen de production *in situ* d'halogénure métallique au voisinage du substrat, la régulation du débit de chlore injecté dans ledit moyen permet, pour des températures supérieures à 350°C, un contrôle précis du débit du Cu₃Cl₃ mis en contact avec le substrat et donc une concentration de ce dernier dans la phase vapeur suffisamment grande pour obtenir des vitesses de dépôt de cuivre de l'ordre du micromètre par minute.

Egalement de manière avantageuse, l'injection du produit réactant (CuCl) au niveau de la zone de dépôt de cuivre 12 est réalisée à travers une série d'orifices, uniformément répartis sur le périmètre entourant le substrat 30 (non représentés aux figures 1 et 2), assurant la communication entre le moyen de production d'halogénure 11 et la zone de dépôt 12 .

### EXEMPLE 1 : Mise en oeuvre du procédé : dépôt de cuivre sur un substrat à zones hétérogènes, dans un dispositif tel que décrit aux figures 1 et 2.

Un substrat présentant des zones de silicium et des zones d'oxyde de silicium permet, dans les conditions définies ci-après, d'obtenir de façon sélective un dépôt de cuivre sur le silicium uniquement.

L'halogénure de cuivre est formé dans le moyen de production d'halogénure (de forme annulaire), entourant le substrat et situé à 1-2 cm dudit substrat, en envoyant du chlore gazeux sur des rubans de cuivre chauffés entre 500°C et 700°C, de préférence à 650°C. Les parois de la chambre de réaction 10 sont maintenues à une température > 250°C, ce qui permet de limiter les recondensations de CuCl sur ces parois. De plus, le chauffage des parois 27 de la coupelle 20 du moyen de production d'halogénure 11 est important car :
. la tension de vapeur de CuCl est trop faible à basse température, pour pouvoir assurer un transfert en quantités suffisantes de CuCl dans la zone de dépôt de métal solide ;
. ce n'est qu'au dessus de 250°C que la réac=ion de formation de CuCl est totale et permet d'obtenir dans la chambre de réaction du CuCl exempt de chlore résiduel ; et
. au dessous de 500°C, la cinétique de formation de CuCl est trop lente pour pouvoir conduire à des débits suffisants.

Le composé obtenu (Cu₃Cl₃), dans lequel le cuivre est dans un état d'oxydation +1, réagit en phase gazeuse avec un mélange de gaz réducteurs (H₂ et SiH₄) au contact dudit substrat porté à 350°C, de manière à ce que la pression totale dans la chambre de réaction 10 soit de 100 pascals, la pression partielle de gaz réducteurs soit de 1 pascal (H₂ : 0,8 pascal ; SiH₄ : 0,2 pascal) et la pression d'halogénure de cuivre soit de 1 pascal ; on obtient alors un dépôt de cuivre à une vitesse de 0,5 micron/minute. La valeur de résistivité mesurée est d'environ 2 µohms cm-1, valeur proche de celle du cuivre massif. Ceci est notamment dû à l'absence de réactants solides pouvant se piéger dans le cuivre ainsi qu'à la forte tension de vapeur des réactants gazeux éliminés par pompage.

### EXEMPLE 2 : Dépôt de cuivre sur un substrat homogène.

a) on choisit comme substrat une plaquette de silicium ;
b) le substrat est placé sur une sole chauffante permettant de monter à des températures comprises entre 200°C et 400°C ;
c) le CuCl est formé dans une partie de la chambre très proche du substrat, en envoyant du chlore sur des rubans de cuivre chauffés entre 500°C et 700°C.

La suite du protocole est identique à celle de l'exemple 1.

Ainsi que cela ressort de ce qui précède, l'invention ne se limite nullement à ceux de ses modes de mise en oeuvre, de réalisation et d'application qui viennent d'être décrits de façon plus explicite ; elle en embrasse au contraire toutes les variantes qui peuvent venir à l'esprit du technicien en la matière, sans s'écarter du cadre, ni de la portée de la présente invention.

## Revendications

1. Procédé de dépôt de cuivre en phase vapeur, sur un substrat, par réduction d'un halogénure de cuivre à l'état gazeux, caractérisé en ce qu'il comprend :
(a) la production dudit halogénure de cuivre, sous forme CuCl, *in situ,* à partir d'un moyen de production (11) inclus dans une chambre de réaction (10) contenant le substrat, par mise en contact de chlore gazeux avec du cuivre solide porté à une température comprise entre 500°C et 700°C, et
(b) la réduction, -dans ladite chambre de réaction maintenue à une pression totale, comprise entre 13,3 et 133,3 pascals (0,1 et 1 torr)-, dudit halogénure de cuivre gazeux produit au cours de l'étape (a) et dont la pression partielle est comprise entre 1,33 et 13,3 pascals (0,01 et 0,1 torr), en présence d'au moins un gaz réducteur, lequel gaz a une pression partielle de l'ordre de celle de l'halogénure de cuivre, pour l'obtention d'un dépôt de métal pur, à une vitesse de l'ordre du µm par minute, sur ledit substrat porté à une température comprise entre 200°C et 400°C.

2. Procédé selon la revendication 1, caractérisé en ce que le gaz réducteur est choisi dans le groupe comprenant l'hydrogène, SiH₄, Si₂H₆, Si₃H₈, SiH₂Cl₂, SiHCl₃, SiH₃Cl.

3. Procédé selon la revendication 1 ou la revendication 2, caractérisé en ce que le substrat est choisi dans le groupe qui comprend les substrats semi-conducteurs, notamment à base de silicium et les substrats en matière plastique.

4. Procédé selon l'une quelconque des revendications 1 à 3, caractérisé en ce que lorsque la surface du substrat est de nature homogène, silicium ou métal, on obtient un dépôt en couche homogène de l'ordre du µm/min.

5. Procédé selon l'une quelconque des revendications 1 à 3, caractérisé en ce que lorsque la surface du substrat présente des structures de natures différentes, ladite couche de métal se dépose sélectivement au niveau de certaines zones.

6. Procédé selon l'une quelconque des revendications 1 à 5, caractérisé en ce que l'halogène gazeux et/ou le gaz réducteur sont associés à un gaz porteur neutre.

7. Dispositif pour la mise en oeuvre du procédé selon l'une quelconque des revendications 1 à 6, du type comprenant une chambre de réaction (10) incluant un substrat (30), des moyens de chauffage dudit substrat (34) et au moins une source de gaz réducteur (23), caractérisé en ce que ladite chambre de réaction inclut, en outre, un moyen (11) de production *in situ* d'un halogénure de métal gazeux, qui comprend au moins en combinaison :
. une source d'halogène gazeux (22), associée à des moyens de régulation du débit d'entrée dudit halogène ;
. un support (20) contenant un métal sous forme solide ;
. des moyens d'homogénéisation du flux de sortie de l'halogénure métallique gazeux formé, vers le substrat ; et
. des moyens de chauffage et de régulation de sa température (21),
lequel moyen (11) de production d'halogénure métallique gazeux entoure ledit substrat et permet une injection radiale uniforme de l'halogénure sur le substrat.

8. Dispositif selon la revendication 7, caractérisé en ce que ledit moyen (11) de production d'halogénure métallique gazeux comprend en outre une source de gaz porteur.

## Patentansprüche

1. Verfahren zur Ablagerung von Kupfer in der Dampfphase auf einem Substrat durch Reduktion eines Kupferhalogenids im gasförmigen Zustand, dadurch **gekennzeichnet**, daß es folgendes umfaßt:
(a) die Herstellung des Kupferhalogenids in der Form CuCl in situ ausgehend von einem Herstellungsmittel (11), das in einer Reaktionskammer (10) eingeschlossen ist, die das Substrat enthält, durch Inkontaktbringen von gasförmigem Chlor mit festem Kupfer, das auf einer Temperatur, die zwischen 500 °C und 700 °C liegt, gehalten wird, und
(b) die Reduktion - in der Reaktionskammer, die auf einem Gesamtdruck erhalten wird, der zwischen 13,3 und 133,3 Pascal (0,1 und 1 Torr) liegt - des gasförmigen Kupferhalogenids, das im Verlauf des Schritts (a) hergestellt worden ist und dessen Partialdruck zwischen 1,33 und 13,3 Pascal (0,01 und 0,1 Torr) liegt, in Gegenwart von wenigstens einem Reduktionsgas, welches Gas einen Partialdruck in der Größenordnung desjenigen des Kupferhallogenids hat, zum Erhalten einer Ablagerung von reinem Metall mit einer Geschwindigkeit in der Größenordnung von µm/min auf dem Substrat, das auf einer Temperatur gehalten wird, die zwischen 200 °C und 400 °C liegt.

2. Verfahren gemäß Anspruch 1 dadurch **gekennzeichnet,** daß das Reduktionsgas aus der Gruppe gewählt ist, die Wasserstoff, SiH₄, Si₂H₆, Si₃H₈, SiH₂Cl₂, SiHCl₃, SiH₃Cl enthält.

3. Verfahren gemäß Anspruch 1 oder Anspruch 2 dadurch **gekennzeichnet**, daß das Substrat aus der Gruppe gewählt ist, welche Halbleitersubstrate, insbesondere auf der Basis von Silizium, und Substrate aus Kunststoff umfaßt.

4. Verfahren gemäß irgendeinem der Ansprüche 1 bis 3, dadurch **gekennzeichnet,** daß man, wenn die Oberfläche des Substrats von homogener Art, Silizium oder Metall, ist, eine Ablagerung in homogener Schicht, in der Größenordnung von µm/min erhält.

5. Verfahren gemäß irgendeinem der Ansprüche 1 bis 3, dadurch **gekennzeichnet**, daß sich, wenn die Oberfläche des Substrats Strukturen von unterschiedlichen Arten aufweist, die Schicht aus Metall selektiv auf dem Niveau gewisser Zonen bzw. in gewissen Zonen ablagert.

6. Verfahren gemäß irgendeinem der Ansprüche 1 bis 5 dadurch **gekennzeichnet**, daß das gasförmige Halogen und/oder das Reduktionsgas mit einem neutralen Trägergas vereinigt werden.

7. Einrichtung für die Durchführung des Verfahrens gemäß irgendeinem der Ansprüche 1 bis 6, von der Art, welche eine Reaktionskammer (10) umfaßt, die ein Substrat (30) einschließt, sowie Mittel (34) für die Erhitzung des Substrats und wenigstens eine Reduktionsgasquelle (23), dadurch **gekennzeichnet,** daß die Reaktionskammer außerdem ein Mittel (11) für die Herstellung von gasförmigem Metallhalogenid in situ einschließt, welches wenigstens in Kombination folgendes umfaßt:
. eine Quelle von gasförmigem Halogen (22), die mit Mitteln für die Regulierung der Eintrittsmenge des Halogens verbunden ist;
. einen Träger (20) der ein Metall in fester Form enthält;
. Mittel für die Homogenisierung des Flusses des Austritts des gebildeten gasförmigen Metallhalogenids nach dem Substrat hin; und
. Mittel (21) für die Erhitzung und die Regulierung seiner Temperatur,
welches Mittel (11) für die Herstellung von gasförmigem Metallhalogenid das Substrat umgibt und ein gleichförmiges radiales Injizieren des Halogenids auf das Substrat gestattet.

8. Einrichtung gemäß Anspruch 7 dadurch **gekennzeichnet,** daß das Mittel (11) für die Herstellung von gasförmigem Metallhalogenid außerdem eine Quelle für Trägergas umfaßt.

## Claims

1. A method of depositing copper in the vapour phase on a substrate by reduction of a copper halide to the gaseous state, characterised in that it comprises:
(a) the production of the said copper halide in CuCl form, *in situ,* from a production means (11) enclosed in a reaction chamber (10) containing the substrate, by bringing gaseous chloride into contact with the solid copper which is raised to a temperature comprised between 500°C and 700°C and
(b) the reduction - within the said reaction chamber maintained at a total pressure comprised between 13.3 and 133.3 pascals (0.1 and 1 torr) - of the said gaseous copper halide produced during the course of stage (a) and of which the partial pressure is comprised between 1.33 and 13.3 pascals (0.01 and 0.1 torr) in the presence of at least one reducing gas, which gas is at a partial pressure of the order of that of the copper halide, in order to obtain a deposition of pure metal at a rate of around µm per minute on the said substrate brought to a temperature comprised between 200°C and 400°C.

2. A method according to Claim 1, characterised in that the reducing gas is chosen from the group containing hydrogen, SiR₄, Si₂H₆, Si₃R₈, SiK₂Cl₂, SiHCl₃, SiH₃Cl.

3. A method according to Claim 1 or Claim 2, characterised in that the substrate is chosen from the group which comprises the semi-conductor substrates, particularly those which are silicon-based, and the substrates of plastics material.

4. A method according to any one of Claims 1 to 3, characterised in that when the surface of the substrate is of an homogeneous nature, silicon or metal, a deposit is obtained which is an homogeneous layer of the order of µm/min.

5. A method according to any one of Claims 1 to 3, characterised in that when the surface of the substrate exhibits structures of different natures, the said layer of metal is selectively deposited at the level of certain zones.

6. A method according to any one of Claims 1 to 5, characterised in that the gaseous halogen and/or the reducing gas are associated with a neutral carrier gas.

7. An apparatus for carrying out the method according to any one of Claims 1 to 6, of the type comprising a reaction chamber (10) enclosing a substrate (30), means (34) of heating the said substrate and at least one reducing gas source (23), characterised in that the said reaction chamber further encloses a means (11) for the *in situ* production of a gaseous metal halide, which comprises at least in combination:
. a source (22) of gaseous halide associated with means of regulating the rate of inlet flow of the said halogen;
. a support (20) containing a metal in solid form;
. means of homogenising the outlet flow of the gaseous metallic halide formed towards the substrate and
. means of heating and regulating its temperature (21), which means (11) for the production of gaseous metallic halide surrounds the said substrate and permits uniform radial injection of the halide onto the substrate.

8. An apparatus according to Claim 7, characterised in that the said means (11) of producing gaseous metallic halide further comprises a source of carrier gas.
